# EUROPÄISCHE PATENTSCHRIFT

(11) **EP 2 857 853 B1**
(45) Veröffentlichungstag und Bekanntmachung des Hinweises auf die Patenterteilung: **17.04.2019**
(21) Anmeldenummer: 13187485.1
(22) Anmeldetag: 07.10.2013
(51) Int. Cl.: G01R 31/327, G01D 5/245, H01H 1/00

(54) **Vorrichtung und Verfahren zum Überprüfen eines Schaltvorgangs eines elektrischen Schalters**
Method and device for checking a switching process of an electrical switch
Dispositif et procédé de vérification d'un processus de commutation d'un commutateur électrique

(43) Veröffentlichungstag der Anmeldung: 08.04.2015
(73) Patentinhaber: Omicron electronics GmbH, 6833 Klaus (AT)
(72) Erfinder: Walch, Daniel, 6800 Feldkirch (AT)
(74) Vertreter: Banzer, Hans-Jörg

(56) Entgegenhaltungen:
- EP-A1- 2 597 428
- DE-A1- 19 545 999
- DE-U1-202005 014 666
- US-A1- 2007 000 325
- US-A1- 2012 319 692

## Beschreibung

Die Erfindung betrifft Verfahren und Vorrichtungen zum Überprüfen eines Schaltvorgangs eines elektrischen Schalters. Die Erfindung betrifft insbesondere Verfahren und Vorrichtungen zum Überprüfen von Öffnungs- und Schließvorgängen von elektrischen Höchst-, Hoch- und Mittelspannungsschaltern.

Elektrische Leistungsschalter und Lastschalter, wie z.B. Höchst-, Hoch- und Mittelspannungsschalter, müssen nach einer Neuinstallation, nach einem Umbau oder bei einer Revision geprüft werden, bevor sie erstmalig oder erneut in Betrieb genommen werden dürfen. Eine wichtige Prüfung ist dabei die Aufnahme eines so genannten Weg-Zeitdiagramms. Damit kann insbesondere überprüft werden, ob der Öffnungsvorgang oder Schließvorgang des Schalters schnell genug abläuft und/oder ob am Ende eines Weges ein Abbremsen eines beweglichen Schaltelements des Schalters in der gewünschten Art und Weise erfolgt.

Bei herkömmlichen Verfahren und Vorrichtungen kann dazu zwischen dem beweglichen Schaltelement des Schalters und einem festen Teil des Schalters ein Wegaufnehmer oder ein Winkelaufnehmer angebracht werden. Mit Hilfe einer geeigneten Prüfvorrichtung kann während des Schaltvorgangs der Weg oder der Winkel über der Zeit aufgezeichnet werden und mit Hilfe des so bestimmten Weg- oder Winkel-Zeitdiagramms können alle notwendigen weiteren Analysen durchgeführt werden. Das Anbringen des Weg- oder Winkelaufnehmers bei herkömmlichen Vorrichtungen und Verfahren kann sich als verhältnismäßig aufwändig und kompliziert darstellen.

Die EP 2 597 428 A1, die als Basis für den Oberbegriff der unabhängigen Ansprüche dient, offenbart eine Vorrichtung zum Auswerten mechanischer Eigenschaften eines Schalters.

Die US 2013/0319692 A1 offenbart ein mobiles System zum Messen abnormaler Detektionsparameters eines Schalters. Ein magnetischer Drehkodierer kann als Drehwinkelsensor verwendet werden.

Die DE 195 45 999 A1 offenbart einen inkrementalen Stellungsgeber zur Weg- oder Drehwinkelmessung, der Markierungen in sich wiederholenden Folgen aufweist. Die Abtastung kann magnetisch erfolgen.

Die DE 20 2005 014 666 U1 offenbart einen Sensor zur Richtungserkennung, der magnetische Sensorelemente umfassen kann.

Weitere Verfahren und Vorrichtungen verwenden beispielsweise mehrere optische Markierungen. Die konsistente Anbringung mehrerer optischer Markierungen an einem schwer zugänglichen beweglichen Schaltelement kann ebenfalls schwierig sein.

Der Erfindung liegt daher die Aufgabe zugrunde, verbesserte Verfahren und Vorrichtungen zum Überprüfen eines Schaltvorgangs eines elektrischen Schalters bereitzustellen, welche insbesondere eine Montage vereinfachen und auch bei geringem Raumangebot in der Umgebung der beweglichen Teile des Schalters einfach verwendbar und betreibbar sind.

Es werden ein Verfahren und eine Vorrichtung mit den in den unabhängigen Ansprüchen definierten Merkmalen angegeben. Die abhängigen Ansprüche definieren Ausführungsbeispiele.

Bei einem Verfahren zum Überprüfen eines Schaltvorgangs eines elektrischen Schalters nach einem Ausführungsbeispiel wird eine Bewegung eines beweglichen Schaltelements des elektrischen Schalters während des Schaltvorgangs erfasst. Dabei wird ein Markierungselement verwendet, das ein Magnetisierungsmuster mit mehreren magnetischen Markierungen aufweist. Das Erfassen der Bewegung des beweglichen Schaltelements umfasst ein Bestimmen einer Weglänge einer Relativbewegung zwischen dem Markierungselement und einem Sensor.

Durch die Verwendung eines Markierungselements, das bereits mehrere magnetische Markierungen in einem Magnetisierungsmuster aufweist, kann die Montage der für die Erfassung der Bewegung erforderlichen Elemente vereinfacht werden. Das Markierungselement in Kombination mit dem Sensor erlaubt aufgrund der mehreren magnetischen Markierungen die Bestimmung der Relativbewegung zwischen dem Markierungselement und dem Sensor. Eine zuverlässige Bestimmung der Weglänge der Relativbewegung kann aufgrund der magnetischen Positions- und/oder Bewegungskodierung auch dann erfolgen, wenn während des Tests des Schalters das Markierungselement nicht optisch erfasst werden kann, beispielsweise aufgrund ungünstiger Lichtverhältnisse.

Das Markierungselement kann an dem elektrischen Schalter mit einem lösbaren Haltemittei angebracht werden. Das Markierungselement kann reversibel lösbar angebracht werden, so dass es ohne Zerstörung des Markierungselements und/oder der Komponente des elektrischen Schalters, an der das Markierungselement befestigt wird, wieder entfernt werden kann.

Das Markierungselement kann reversibel lösbar an dem beweglichen Schaltelement angebracht werden. Das Markierungselement kann reversibel lösbar an einer Komponente des Schalters, die sich bei der Bewegung des beweglichen Schaltelements bewegt, angebracht werden. Dies erlaubt es, ein relativ kompaktes, passives Bauelement zur Erfassung der Bewegung des Schaltelements an einem beweglichen Teil des elektrischen Schalters anzubringen. Eine derartige Anbringung des Markierungselements kann selbst bei eingeschränkter Zugänglichkeit des bewegten Teils einfach vorgenommen werden.

Das Magnetisierungsmuster kann ein sich entlang einer Richtung periodisch wiederholendes Muster magnetischer Markierungen aufweisen. Die Richtung, entlang der sich das periodisch wiederholende Muster erstreckt, kann parallel zu einer Bewegungsrichtung des beweglichen Schaltelements angeordnet sein.

Das Magnetisierungsmuster kann absolut kodiert sein. D.h., das Magnetisierungsmuster kann derart kodiert sein, dass der Sensor auch die absolute Position des Magnetisierungsmusters relativ zum Sensor und nicht nur eine Positionsänderung relativ zum Sensor bestimmen kann.

Der Sensor wird lösbar an einem feststehenden Gestell des elektrischen Schalters befestigt. Der Sensor kann so an dem feststehenden Gestell des elektrischen Schalters befestigt werden, dass er zerstörungsfrei wieder von dem Gestell entfernt werden kann.

Der Sensor wird mit einer feststellbaren beweglichen Befestigungseinrichtung an dem Gestell befestigt und in der Nähe des Markierungselements positioniert. Die Befestigungseinrichtung erleichtert die Befestigung und Positionierung des Sensors insbesondere dann, wenn das bewegliche Schaltelement schwer zugänglich ist.

Die Befestigungseinrichtung umfasst einen beweglichen Arm. Der bewegliche Arm umfasst wenigstens ein starres Element und wenigstens ein feststellbares Kugelgelenk. Der bewegliche Arm kann mehrere starre Elemente umfassen, die durch wenigstens ein feststellbares Kugelgelenk verbunden sind. Der bewegliche Arm kann eine Halterung zur Befestigung des Arms an dem Gestell des Schalters umfassen.

Die Befestigungseinrichtung kann wenigstens einen weiteren Arm zum Abstützen des Sensors umfassen, mit dem der Sensor bei dem Verfahren stabilisiert wird.

Das Markierungselement kann aus permanentmagnetischem Material bestehen oder ein permanentmagnetisches Material umfassen. Die Kodierung einer Relativposition oder einer Relativbewegung kann beispielsweise durch eine sich verändernde Polarität eines Magnetfels an der dem Sensor zugewandten Oberfläche des Markierungselements erfolgen. Beispielsweise kann das Markierungselement mehrere permanentmagnetische Abschnitte aufweisen, die alternierend eine Nord-Magnetisierung und eine Süd-Magnetisierung an der dem Sensor zugewandten Oberfläche aufweisen. Es können auch komplexere Muster verwendet werden, beispielsweise für eine absolute Positionskodierung.

Nach einem weiteren Ausführungsbeispiel wird eine Vorrichtung zum Überprüfen eines Schaltvorgangs eines elektrischen Schalters angegeben. Der elektrische Schalter weist ein bewegliches Schaltelement auf. Die Vorrichtung umfasst ein Markierungselement mit einem Magnetisierungsmuster, das mehrere magnetische Markierungen umfasst. Die Vorrichtung umfasst einen Sensor zum Erfassen einer Relativbewegung zwischen dem Markierungselement und dem Sensor. Die Vorrichtung umfasst eine Verarbeitungseinheit, die mit dem Sensor gekoppelt ist und die eingerichtet ist, um eine Weglänge der mit dem Sensor erfassten Relativbewegung zu bestimmen.

Die Vorrichtung erleichtert die Erfassung der Bewegung des beweglichen Schaltelements, da mehrere magnetische Markierungen auf dem Markierungselement zusammengefasst sind, das an einem beweglichen Teil des elektrischen Schalters angebracht werden kann.

Die Vorrichtung kann ein Haltemittel zum reversibel lösbaren Anbringen des Markierungselements an dem beweglichen Schaltelement umfassen. Die Vorrichtung kann ein Haltemittel zum reversibel lösbaren Anbringen des Markierungselements an einer Komponente des elektrischen Schalters, die sich bei einer Bewegung des beweglichen Schaltelements bewegt, umfassen.

Das Markierungselement kann aus einem permanentmagnetischem Material bestehen oder kann ein permanentmagnetisches Material umfassen.

Das Magnetisierungsmuster kann ein sich entlang einer Richtung periodisch wiederholendes Muster magnetischer Markierungen aufweisen. Das Markierungselement kann mehrere permanentmagnetische Abschnitte aufweisen, die alternierend eine Nord-Magnetisierung und eine Süd-Magnetisierung an der dem Sensor zugewandten Seite aufweisen.

Das Magnetisierungsmuster kann absolut kodiert sein.

Die Vorrichtung umfasst eine feststellbare bewegliche Befestigungseinrichtung zum lösbaren Befestigen des Sensors an einem Gestell des elektrischen Schalters.

Die Befestigungseinrichtung umfasst einen beweglichen Arm, der wenigstens ein starres Element und wenigstens ein feststellbares Kugelgelenk aufweist.

Die Befestigungseinrichtung kann wenigstens einen weiteren Arm zum Abstützen des Sensors umfassen.

Bei Verfahren und Vorrichtungen nach Ausführungsbeispielen kann das Markierungselement flexibel sein. Dies erleichtert die Anbringung der Vorrichtung bei einem Feldeinsatz und erlaubt eine Verwendung bei unterschiedlichen Schaltertypen. Beispielsweise kann das Markierungselement so verformbar sein, dass es sowohl auf einer ebenen Oberfläche als auch auf einer gekrümmten Oberfläche eines beweglichen Teils des elektrischen Schalters angebracht werden kann.

Das Markierungselement kann eine Dicke aufweisen, die viel kleiner als eine Länge des Markierungselements sein kann. Das Markierungselement kann ein Band sein.

Bei Verfahren und Vorrichtungen nach Ausführungsbeispielen kann das Markierungselement ein passives Element sein.

Bei Verfahren und Vorrichtungen nach Ausführungsbeispielen kann die Bewegung des beweglichen Schaltelements relativ zu dem Sensor erfasst werden. Die Erfassung der Bewegung kann zeitaufgelöst erfolgen. Für einen ortsfest an einem unbeweglichen Teil des Schalters befestigten Sensor definiert die Relativbewegung zwischen dem Schaltelement und dem Sensor auch die Relativbewegung zwischen dem Schaltelement und einem feststehenden Teil des elektrischen Schalters. Mit den so bestimmten Informationen über Beschleunigung, Geschwindigkeit und Position des Schaltelements kann der Schaltvorgang, insbesondere ein Öffnungsvorgang und/oder ein Schließvorgang, des elektrischen Schalters analysiert werden. Insbesondere kann überprüft werden, ob der Öffnungsvorgang oder Schließvorgang des Schalters schnell genug abläuft und ob am Ende des Vorgangs ein Abbremsen des Schaltelements in der gewünschten Art und Weise erfolgt.

Die Verarbeitungseinheit kann eingerichtet sein, um abhängig von der ermittelten Weglänge der Relativbewegung automatisch zu bestimmen, ob ein Öffnungsvorgang und/oder ein Schließvorgang des elektrischen Schalters vorgegebenen Gütekriterien genügt. Die Verarbeitungseinheit kann eingerichtet sein, um abhängig von der ermittelten Weglänge der Relativbewegung automatisch eine Warnung zu generieren, wenn der Bewegungsablauf anzeigt, dass der elektrische Schalter ersetzt oder gewartet werden muss.

Bei Vorrichtungen und Verfahren nach Ausführungsbeispielen wird der Sensor mittels einer Befestigungseinrichtung, die einen beweglichen Arm umfasst, so vor dem Markierungselement positioniert, dass er die Position oder die Bewegung des Markierungselements gut erfassen kann. Der Arm soll in einem Zustand, in dem er nicht fixiert ist, möglichst mehrere Freiheitsgrade aufweisen, um die Position des Sensors möglichst optimal einstellen zu können. Der Arm soll in einem Zustand, in dem er fixiert ist, möglichst starr sein, damit der Sensor während der Bewegung des Schalters möglichst wenig gegenüber den feststehenden Teilen des Schalters vibriert.

Der bewegliche Arm kann aus einer Konstruktion von festen Teilen und Kugelgelenken bestehen, welche vorzugsweise mit Feststellschrauben in einer frei wählbaren Position fixiert werden können. Ein weiterer Arm oder mehrere weitere Arme können dazu verwendet werden, den Sensor zusätzlich in der Nähe des Markierungselements zu fixieren, um die Vibrationen des Sensors gegenüber den feststehenden Teilen des Schalters zu unterdrücken.

Ein System nach einem Ausführungsbeispiel umfasst einen elektrischen Schalter und eine Vorrichtung nach einem Ausführungsbeispiel, die an dem elektrischen Schalter angebracht ist.

Die vorliegende Erfindung wird nachfolgend unter Bezugnahme auf die Zeichnungen anhand bevorzugter Ausführungsformen erläutert werden. In den Zeichnungen bezeichnen identische Bezugszeichen identische Elemente.
Figur 1 zeigt eine schematische Darstellung einer Vorrichtung nach einem Ausführungsbeispiel, bei der ein Markierungselement an einem sich linear bewegenden Teil des elektrischen Schalters angebracht wird.
Figur 2 zeigt eine schematische Darstellung einer Vorrichtung nach einem Ausführungsbeispiel, bei der ein Markierungselement an einem sich rotatorisch bewegenden Teil des elektrischen Schalters angebracht wird.
Figur 3 illustriert ein Markierungselement einer Vorrichtung nach einem Ausführungsbeispiel, das mit einem Haltemittel reversibel lösbar befestigt ist.
Figur 4 illustriert ein Markierungselement einer Vorrichtung nach einem weiteren Ausführungsbeispiel, das mit einem Haltemittel reversibel lösbar befestigt ist.
Figur 5 illustriert ein Markierungselement einer Vorrichtung nach einem Ausführungsbeispiel, das ein Muster von sich periodisch wiederholenden magnetischen Markierungen umfasst.
Figur 6 illustriert ein Markierungselement einer Vorrichtung nach einem Ausführungsbeispiel, das absolut kodiert ist.

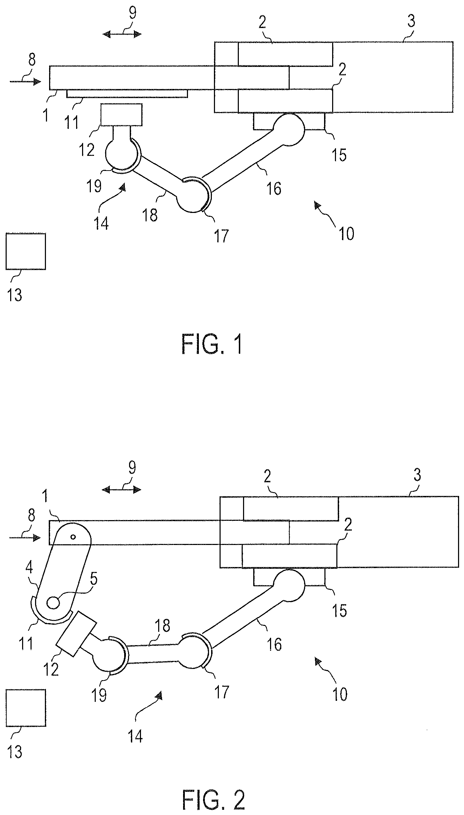

Figur 1 zeigt eine Vorrichtung 10 zum Überprüfen eines Schaltvorgangs eines elektrischen Schalters. Der elektrische Schalter kann beispielsweise ein elektrischer Höchst-, Hoch- oder Mittelspannungsschalter sein. Der elektrische Schalter kann eine Schaltkammer 3 umfassen, in der feststehende Kontakte 2 ortsfest relativ zu der Schaltkammer 3 angeordnet sind. Die feststehenden Kontakte 2 können beispielsweise mit der Schaltkammer 3 mechanisch verbunden sein. Ein bewegliches Schaltelement 1 des elektrischen Schalters kann durch eine Öffnung der Schaltkammer 3 in die Schaltkammer 3 derart hineinragen, dass bei einer Bewegung des beweglichen Schaltelements 1 in einer Bewegungsrichtung 8 ein elektrischer Kontakt zwischen den feststehenden Kontakten 2 und dem beweglichen Schaltelement 1 wahlweise hergestellt oder unterbrochen werden kann.

Die Vorrichtung 10 dient zum Überprüfen der korrekten Funktionsweise des elektrischen Schalters. Die Vorrichtung 10 umfasst ein Markierungselement 11 mit einem Magnetisierungsmuster, das mehrere magnetische Markierungen umfasst. Die mehrere magnetischen Markierungen können beispielsweise Abschnitte unterschiedlicher Polarität des Magnetfeldes und/oder unterschiedlicher Magnetfeldstärke und/oder unterschiedlicher Magnetfeldverteilungen umfassen, wie noch detaillierter beschrieben wird. Ein Sensor 12 wird in einer Umgebung des Markierungselements 11 positioniert. Der Sensor 12 ist so eingerichtet, dass er wenigstens eine Relativbewegung zwischen dem Sensor 12 und dem Markierungselement 11 detektieren kann. Der Sensor 12 kann so eingerichtet sein, dass er eine absolute Position des Markierungselements 11 relativ zu dem Sensor 12 erkennen kann. Dazu kann das Magnetisierungsmuster des Markierungselements 11 absolut kodiert sein.

Das Markierungselement 11 wird für eine Überprüfung des Schaltvorgangs an einem beweglichen Teil des Schalters angebracht. Das Markierungselement 11 kann an dem beweglichen Schaltelement 1 angebracht werden. Das bewegliche Schaltelement 1 kann einen Schaltkontakt tragen. Das Markierungselement 11 kann so an dem beweglichen Schaltelement 1 angebracht werden, dass eine Richtung, entlang der das Markierungselement mehrere unterschiedliche magnetische Markierungen aufweist, parallel zu der Bewegungsrichtung 8 des beweglichen Schaltelements 1 ist. Das Markierungselement 11 kann reversibel lösbar an dem Schaltelement 11 angebracht werden. Dies erlaubt es, nach Abschluss der Überprüfung des elektrischen Schalters das Markierungselement 11 von dem elektrischen Schalter zu entfernen und optional für eine Überprüfung eines weiteren elektrischen Schalters zu verwenden.

Der Sensor 12 kann an einem ortsfesten Teil des elektrischen Schalters befestigt werden. Eine Befestigungseinrichtung 14 wird zur Befestigung des Sensors 11 an dem Gestell des Schalters, beispielsweise an der Schaltkammer 3, verwendet. Die Befestigungseinrichtung 14 ist so ausgestaltet, dass sie wenigstens einen Bewegungsfreiheitsgrad und vorteilhaft mehrere Bewegungsfreiheitsgrade aufweist, aber feststellbar ist. Dies erleichtert die Positionierung des Sensors 12 in der Nähe des Markierungselements 11.

Die Befestigungseinrichtung 14 weist einen Arm auf, der mehrere starre Elemente 16, 18 und wenigstens ein feststellbares Kugelgelenk 17, 19 umfasst. Eine Halterung 15 ist so ausgestaltet, dass sie eine Befestigung des Arms an einem ortsfesten Teil des elektrischen Schalters erlaubt. Die Halterung 15 kann für eine reversibel lösbare Befestigung an einem ortsfesten Teil des elektrischen Schalters eingerichtet sein. Ein starres Element 16 des Arms kann an der Halterung 15 gelagert sein. Das starre Element 16 kann über ein feststellbares Kugelgelenk an der Halterung 15 gelagert sein. Ein weiteres starres Element 18 kann über ein feststellbares Kugelgelenk 17 mit dem starren Element 16 verbunden sein. Der Sensor 12, der in einen Lesekopf integriert sein kann, kann über ein weiteres feststellbares

Kugelgelenk 19 an dem weiteren starren Element 18 gelagert sein. Zur Befestigung des Sensors 12 für eine Datenaufnahme können die starren Elemente zunächst so positioniert und die Kugelgelenke dann so festgestellt werden, dass der Sensor 12 in der Nähe des Markierungselements 11 angeordnet ist. Die Fixierung der Kugelgelenke kann beispielsweise mit Fixierschrauben erfolgen. Eine vorgegebene Seite des Sensors 12 kann mit der Richtung 7 ausgerichtet werden, entlang der das bewegliche Schaltelement 1 beweglich ist.

Der Sensor 12 ist über eine drahtlose oder drahtgebundene Datenleitung mit einer Verarbeitungseinheit 13 verbunden. Die Verarbeitungseinheit 13 kann aus der mit dem Sensor 12 erfassten Relativbewegung zwischen dem beweglichen Schaltelement 1 und dem Sensor 12 die Weglänge 9 der Relativbewegung ermitteln. Die Verarbeitungseinheit 13 kann die Weglänge 9 der Relativbewegung zeitaufgelöst ermitteln. Die Verarbeitungseinheit 13 kann eingerichtet sein, um eine Beschleunigung, Geschwindigkeit und/oder Position des beweglichen Schaltelements 1 rechnerisch zu bestimmen. Die Verarbeitungseinheit 13 kann eingerichtet sein, um ein Weg-Zeitdiagramm auf der Grundlage des Ausgangssignals des Sensors 12 zu bestimmen.

Die Verarbeitungseinheit 13 kann eingerichtet sein, um die erfassten Daten automatisch zu analysieren, um den Öffnungsvorgang und/oder den Schließvorgang des elektrischen Schalters zu bewerten. Beispielsweise kann die Verarbeitungseinheit 13 eingerichtet sein, um zu überprüfen, ob der Öffnungsvorgang oder Schließvorgang des Schalters schnell genug abläuft, und/oder ob am Ende des Vorgangs ein Abbremsen des Schaltelements in der gewünschten Art und Weise erfolgt.

Die Verarbeitungseinheit 13 kann eine Schnittstelle zur Kopplung mit einem Antrieb des elektrischen Schalters aufweisen. Über die Schnittstelle kann die Verarbeitungseinheit 13 einen Schaltvorgang auslösen und/oder erkennen, wann ein Schaltvorgang des elektrischen Schalters für die Überprüfung des Schalters ausgelöst wird.

Das Markierungselement 11 muss nicht an dem beweglichen Schaltelement 1 angebracht sein, sondern kann auch an einem anderen beweglichen Teil des elektrischen Schalters angebracht werden, wie in Figur 2 dargestellt ist.

Figur 2 zeigt die Vorrichtung 10, die bei einem elektrischen Schalter verwendet wird, dessen Schaltelement 1 über einen schwenkbar gelagerten Hebel 4 angetrieben werden kann. Der Hebel 4 kann eine Achse oder Welle 5 aufweisen. Das Markierungselement 11 ist an dem Hebel 4 angebracht, also an einem rotierenden Teil des elektrischen Schalters.

Die Verarbeitungseinheit 13 kann eingerichtet sein, um die Winkelbewegung des Hebels 4 zu analysieren. Die Verarbeitungseinheit 13 kann eingerichtet sein, um die mit dem Sensor 12 erfasste Winkelbewegung des drehbar gelagerten Teils 4 des elektrischen Schalters in die korrespondierende Weglänge 9 umzurechnen, um die sich das bewegliche Schaltelement 1 bewegt. Die entsprechenden Informationen über die Geometrie des jeweiligen elektrischen Schalters können in einem Speicher der Verarbeitungseinheit 13 nichtflüchtig gespeichert sein. Die Verarbeitungseinheit 13 kann die Weglänge 9 der Relativbewegung zeitaufgelöst ermitteln. Die Verarbeitungseinheit 13 kann eingerichtet sein, um eine Beschleunigung, Geschwindigkeit und/oder Position des beweglichen Schaltelements 1 rechnerisch zu bestimmen. Die Verarbeitungseinheit 13 kann eingerichtet sein, um ein Weg-Zeitdiagramm auf der Grundlage des Ausgangssignals des Sensors 12 zu bestimmen.

Wenn das Markierungselement 11 an einem drehbar gelagerten Teil 4 des elektrischen Schalters angebracht ist, kann die Richtung, entlang der das Markierungselement 11 positionskodiert ist, senkrecht zu der Drehachse 5 des drehbar gelagerten Teils 4 positioniert werden und die Drehachse 5 wenigstens teilweise umlaufen.

Wie in Figur 2 ebenfalls dargestellt ist, kann das Markierungselement 11 so ausgestaltet sein, dass es auch an einer gekrümmten Oberfläche angebracht werden kann. Das Markierungselement 11 kann eine Dicke aufweisen, die viel kleiner als eine Länge des Markierungselements 11 entlang der längsten Seite des Markierungselements 11 ist. Das Markierungselement 11 kann als ein Band ausgestaltet sein, das flexibel ist.

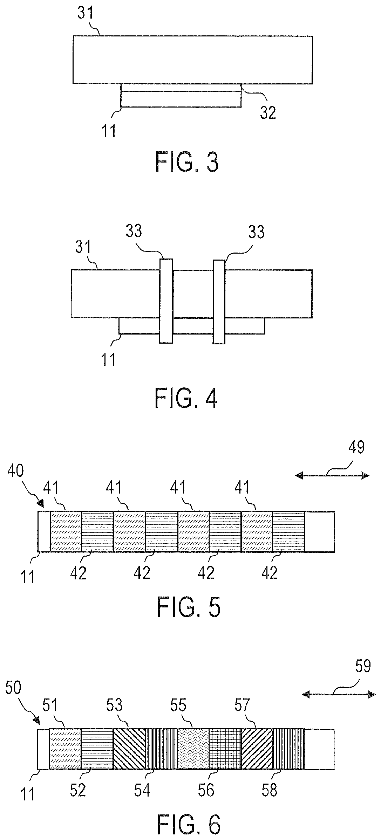

Das Markierungselement 11 kann auf unterschiedliche Weise an einem beweglichen Teil des elektrischen Schalters angebracht werden, wie anhand von Figur 3 und Figur 4 näher erläutert wird.

Figur 3 zeigt ein Markierungselement 11 einer Vorrichtung 10, das mit einem Haltemittel 32 an einem beweglich gelagerten Teil 31 des elektrischen Schalters angebracht ist. Der beweglich gelagerte Teil 31 kann beispielsweise das bewegliche Schaltelement 11 oder eine andere Komponente des elektrischen Schalters sein, die sich bei einer Bewegung des elektrischen Schaltelements 1 ebenfalls bewegt.

Das Haltemittel 32 kann einen Klebstoff umfassen. Das Haltemittel 32 kann ein Klebeband umfassen oder ein Klebeband sein. Das Haltemittel 32 kann aus einem flexiblen Material bestehen, um die wahlweise Befestigung des Markierungselements auf ebenen oder gekrümmten Oberflächen zu erleichtern.

Das Haltemittel 32 kann so ausgestaltet sein, dass das Markierungselement 11 reversibel lösbar an dem beweglich gelagerten Teil 31 des elektrischen Schalters angebracht werden kann. Das Haltemittel 32 kann insbesondere so ausgestaltet sein, dass das Markierungselement und der beweglich gelagerten Teil 31 des elektrischen Schalters nicht zerstört werden, wenn das Markierungselement 11 von dem beweglich gelagerten Teil 31 des elektrischen Schalters entfernt wird.

Figur 4 zeigt ein Markierungselement 11 einer Vorrichtung 10, das mit Haltemitteln 33 reibschlüssig an dem beweglich gelagerten Teil 31 des elektrischen Schalters angebracht ist. Die Haltemittel 33 können aus einem nichtmagnetischen Material bestehen. Die Haltemittel 33 können jeweils einen Schließmechanismus aufweisen, so dass sie den beweglich gelagerten Teil 31 und das daran anliegende Markierungselement ringförmig umgeben. Die Haltemittel 33 können so öffenbar sein, dass das Markierungselement 11 reversibel lösbar an dem beweglich gelagerten Teil 31 des elektrischen Schalters angebracht werden kann. Die Haltemittel 33 können insbesondere so ausgestaltet sein, dass das Markierungselement 11 und der beweglich gelagerten Teil 31 des elektrischen Schalters nicht zerstört werden, wenn die Haltemittel 33 geöffnet werden und das Markierungselement 11 von dem beweglich gelagerten Teil 31 des elektrischen Schalters entfernt wird.

Das Markierungselement, mit dem das bewegliche Schaltelement 1 oder ein anderer beweglicher Teil des elektrischen Schalters zur Weglängenmessung markiert werden kann, kann auf unterschiedliche Weise kodiert sein. Dies wird unter Bezugnahme auf Figur 5 und Figur 6 detaillierter beschrieben.

Figur 5 zeigt ein Markierungselement 11 mit einem Magnetisierungsmuster 40. Das Magnetisierungsmuster 40 weist eine periodische Abfolge von Abschnitten 41, 42 unterschiedlicher Magnetisierung auf. Die Abschnitte 41, 42 alternieren entlang einer Richtung 49. Im Gebrauch der Vorrichtung 10 kann die Richtung 49 mit der Bewegungsrichtung 7 des beweglichen Schaltelements 1 ausgerichtet werden. Bei Anbringung an einem drehbar gelagerten Teil 4 des elektrischen Schalters kann die Längsrichtung 49 des Markierungselements 11 die Drehachse 5 wenigstens teilweise umlaufen.

Die Abschnitte 41, 42, die unterschiedliche magnetische Markierungen bilden, können permanentmagnetisch sein. Die Abschnitte 41, 42, die unterschiedliche magnetische Markierungen bilden, können sich hinsichtlich der Polarität des Magnetfelds an der Oberfläche des Magnetisierungselements 11 und/oder hinsichtlich der Feldstärke an der Oberfläche des Magnetisierungselements unterscheiden. Andere Kodierungen sind möglich.

Der Sensor 12 kann eingerichtet sein, um zu detektieren, wann eine Grenze zwischen benachbarten Abschnitten 41, 42 an dem Sensor 12 vorbeigeführt wird. Dadurch können Änderungen der Relativposition zwischen dem Markierungselement 11 und dem Sensor 12 überwacht werden. Die Verarbeitungseinheit 13 kann die erfassten Änderungen der Relativposition weiter auswerten.

Figur 6 zeigt ein Markierungselement 11 mit einem Magnetisierungsmuster 50. Das Magnetisierungsmuster 50 definiert eine absolute Kodierung. Das Magnetisierungsmuster 50 weist eine Abfolge von Abschnitten 51-58 unterschiedlicher Magnetisierung auf. Die Abschnitte 51-58 sind wenigstens entlang einer Richtung 59 in einer Folge angeordnet. Die Magnetisierung und/oder die magnetische Feldstärke jedes der Abschnitte 51-58 kann in der Folge von Abschnitten 51-58 einmalig sein. D.h. unterschiedliche Abschnitte 51-58, die entlang der Richtung 59 angeordnet sind, weisen jeweils unterschiedliche magnetische Eigenschaften auf, die von dem Sensor 12 ausgelesen werden können. Dies erlaubt dem Sensor 12 zu bestimmen, welcher der Abschnitte 51-58 gerade am nächsten zu dem Sensor positioniert ist.

Im Gebrauch der Vorrichtung 10 kann die Richtung 59 mit der Bewegungsrichtung 7 des beweglichen Schaltelements 1 ausgerichtet werden. Bei Anbringung an einem drehbar gelagerten Teil 4 des elektrischen Schalters kann die Längsrichtung 59 des Markierungselements 11 wenigstens teilweise um die Drehachse 5 laufen.

Die Abschnitte 51-58, die unterschiedliche magnetische Markierungen bilden, können permanentmagnetisch sein. Die Abschnitte 51-58, die unterschiedliche magnetische Markierungen bilden, können sich hinsichtlich der Polarität des Magnetfelds an der Oberfläche des Magnetisierungselements 11 und/oder hinsichtlich der Feldstärke an der Oberfläche des Magnetisierungselements 11 und/oder hinsichtlich eines Magnetfeldmusters über dem entsprechenden Abschnitt 51-58 unterscheiden. Andere Kodierungen sind möglich. Beispielsweise kann in jedem der Abschnitte 51-58 eine Folge von mehreren magnetischen Partikeln angeordnet oder eingebettet sein, die einen Zahl binär kodieren und den Abschnitt 51-58 eindeutig identifizieren. Der Sensor 12 kann eingerichtet sein, um die Kodierung auszulesen.

Der Sensor 12 kann eingerichtet sein, um zu detektieren, welcher der Abschnitte 51-58 gerade vor dem Sensor positioniert ist. Aus den so bekannten absoluten Positionen können Änderungen der Relativposition zwischen dem Markierungselement 11 und dem Sensor 12 überwacht werden. Die Verarbeitungseinheit 13 kann die erfassten Änderungen der Relativposition weiter auswerten.

Während Ausführungsbeispiele unter Bezugnahme auf die Figuren detailliert beschrieben wurden, können bei weiteren Ausführungsbeispielen alternative oder zusätzliche Merkmale verwendet werde. Während beispielsweise ein bandförmiges Markierungselement beschrieben wurde, kann das Markierungselement, das mehrere magnetische Markierungen aufweist, auch eine andere Form aufweisen.

Verfahren und Vorrichtungen nach Ausführungsbeispielen können insbesondere zum Überprüfen von elektrischen Schaltern im Feldeinsatz verwendet werden, ohne darauf beschränkt zu sein.

## Patentansprüche

1. Verfahren zum Überprüfen eines Schaltvorgangs eines elektrischen Schalters (1-3), umfassend:
Erfassen einer Bewegung eines beweglichen Schaltelements (1) des elektrischen Schalters (1-3) während des Schaltvorgangs unter Verwendung eines Markierungselements (11), wobei das Markierungselement (11) ein Magnetisierungsmuster (40; 50), das mehrere magnetische Markierungen (41, 42; 51-58) umfasst, aufweist, und wobei das Erfassen der Bewegung umfasst:
- Bestimmen einer Weglänge (7) einer Relativbewegung zwischen dem Markierungselement (11) und einem Sensor (12),
**dadurch gekennzeichnet, dass** das Verfahren umfasst:
lösbares Befestigen des Sensors (12) an einem feststehenden Gestell (3) des elektrischen Schalters (1-3),
wobei der Sensor (12) mit einer feststellbaren beweglichen Befestigungseinrichtung (14) an dem Gestell (3) befestigt und in der Nähe des Markierungselements (11) positioniert wird und
wobei die Befestigungseinrichtung (14) einen beweglichen Arm umfasst, der wenigstens ein starres Element (16, 18) und wenigstens ein feststellbares Kugelgelenk (17, 19) umfasst.

2. Verfahren nach Anspruch 1, umfassend:
- lösbares Anbringen des Markierungselements (11) an dem elektrischen Schalter mit einem lösbaren Haltemittel (32; 33).

3. Verfahren nach Anspruch 1 oder 2,
wobei das Markierungselement (11) reversibel lösbar an dem beweglichen Schaltelement oder an einer Komponente (4) des Schalters (1-3), die sich bei der Bewegung des beweglichen Schaltelements (1) bewegt, angebracht wird.

4. Verfahren nach einem der Ansprüche 1 bis 3,
wobei das Magnetisierungsmuster (40) ein sich entlang einer Richtung (49) periodisch wiederholendes Muster magnetischer Markierungen (41, 42) aufweist, wobei die Richtung (49) parallel zu einer Bewegungsrichtung (8) des beweglichen Schaltelements (1) angeordnet wird.

5. Verfahren nach einem der Ansprüche 1 bis 3,
wobei das Magnetisierungsmuster (50) absolut kodiert ist.

6. Vorrichtung zum Überprüfen eines Schaltvorgangs eines elektrischen Schalters (1-3), der ein bewegliches Schaltelement (1) aufweist, wobei die Vorrichtung (10) umfasst:
- ein Markierungselement (11), welches ein Magnetisierungsmuster (40; 50) aufweist, das mehrere magnetische Markierungen (41, 42; 51-58) umfasst,
- einen Sensor (12) zum Erfassen einer Relativbewegung zwischen dem Markierungselement (11) und dem Sensor (12) und
- eine Verarbeitungseinheit (13), die mit dem Sensor (12) gekoppelt ist und die eingerichtet ist, um eine Weglänge (7) der mit dem Sensor (12) erfassten Relativbewegung zu bestimmen,
**gekennzeichnet durch**
eine feststellbare bewegliche Befestigungseinrichtung (14) zum lösbaren Befestigen des Sensors (12) an einem Gestell (3) des elektrischen Schalters (1-3), wobei die Befestigungseinrichtung (14) einen beweglichen Arm umfasst, der wenigstens ein starres Element (16, 18) und wenigstens ein feststellbares Kugelgelenk (17, 19) umfasst.

7. Vorrichtung nach Anspruch 6, umfassend
ein Haltemittel (32; 33) zum reversibel lösbaren Anbringen des Markierungselements (11) an dem beweglichen Schaltelement (1) oder an einer Komponente (4) des elektrischen Schalters (1-3), die sich bei einer Bewegung des beweglichen Schaltelements (1) bewegt.

8. Vorrichtung nach Anspruch 6 oder Anspruch 7,
wobei das Magnetisierungsmuster (40) ein sich entlang einer Richtung (49) periodisch wiederholendes Muster magnetischer Markierungen (41, 42) aufweist.

9. Vorrichtung nach Anspruch 6 oder Anspruch 7,
wobei das Magnetisierungsmuster (50) absolut kodiert ist.

10. Vorrichtung nach einem der Ansprüche 6 bis 9,
wobei die Befestigungseinrichtung (14) wenigstens einen weiteren Arm zum Abstützen des Sensors (12) umfasst.

## Claims

1. A method for checking a switching operation of an electric switch (1-3), comprising:
detecting a movement of a movable switching element (1) of the electric switch (1-3) during the switching operation using a marking element (11), the marking element (11) having a magnetization pattern (40; 50) comprising a plurality of magnetic markings (41, 42; 51-58), and the detecting of the movement comprising:
- determining a path length (7) of a relative movement between the marking element (11) and a sensor (12),
**characterised in that** the method comprises:
detachably fastening the sensor (12) to a fixed frame (3) of the electric switch (1-3),
wherein the sensor (12) is fastened to the frame (3) by a lockable movable fastening device (14) and positioned in the vicinity of the marking element (11),
wherein the fastening device (14) comprises a movable arm which comprises at least one rigid element (16, 18) and at least one lockable ball joint (17, 19).

2. The method according to claim 1, comprising:
- detachably attaching the marking element (11) to the electric switch (1-3) by a detachable holding device (32; 33).

3. The method according to claim 1 or claim 2,
wherein the marking element (11) is reversibly detachably attached to the movable switching element or to a component (4) of the switch (1-3), which component moves on the movement of the movable switching element (11).

4. The method according to any one of claims 1-3,
wherein the magnetization pattern (40) has a pattern of magnetic markings (41, 42) periodically repeating along a direction (49), the direction (49) being arranged parallel to a movement direction (8) of the movable switching element (1).

5. The method according to any one of claims 1-3,
wherein the magnetization pattern (50) is absolutely coded.

6. A device for checking a switching operation of an electric switch (1-3) which has a movable switching element (1), the device (10) comprising:
- a marking element (11) which has a magnetization pattern (40; 50) comprising a plurality of magnetic markings (41, 42; 51-58),
- a sensor (12) for detecting a relative movement between the marking element (11) and the sensor (12),
- a processing unit (13) which is coupled to the sensor (12) and which is configured to determine a path length (7) of the relative movement detected by the sensor (12),
**characterised by**
a lockable movable fastening device (14) for detachably fastening the sensor (12) to a frame (3) of the electric switch (1-3),
wherein the fastening device (14) comprising a movable arm which comprises at least one rigid element (16, 18) and at least one lockable ball joint (17, 19).

7. The device according to claim 6, comprising
a holding means (32; 33) for reversibly detachably attaching the marking element (11) to the movable switching element (1) or to a component (4) of the electric switch (1-3), which component moves on a movement of the movable switching element (1).

8. The device according to claim 6 or claim 7,
wherein the magnetization pattern (40) has a pattern of magnetic markings (41, 42) periodically repeating along a direction (49).

9. The device according to claim 8,
wherein the magnetization pattern (50) is absolutely coded.

10. The device according to any one of claims 6-9,
wherein the fastening device (14) comprises at least one further arm for supporting the sensor (12).

## Revendications

1. Procédé de contrôle d'une opération de commutation d'un commutateur électrique (1-3) comprenant :
la détection d'un déplacement d'un élément de commutation mobile (1) du commutateur électrique (1-3) au cours de l'opération de commutation en utilisant un élément de marquage (11), dans lequel l'élément de marquage (11) présente un schéma de magnétisation (40 ; 50) qui comprend plusieurs marquages magnétiques (41, 42 ; 51-58) et dans lequel la détection du mouvement comprend :
- la détermination d'une longueur de trajet (7) d'un mouvement relatif entre l'élément de marquage (11) et un capteur (12),
**caractérisé en ce que** le procédé comprend :
la fixation amovible du capteur (12) sur un cadre fixe (3) du commutateur électrique (1-3),
dans lequel le capteur (12) est fixé sur le cadre (3) à l'aide d'un dispositif de fixation mobile fixable (14) et est positionné au voisinage de l'élément de marquage (11) et
dans lequel le dispositif de fixation (14) comprend un bras mobile qui comprend au moins un élément rigide (16, 18) et au moins un joint sphérique fixable (17, 19).

2. Procédé selon la revendication 1, comprenant :
- le montage amovible de l'élément de marquage (11) sur le commutateur électrique avec un moyen de support amovible (32 ; 33).

3. Procédé selon la revendication 1 ou 2,
dans lequel l'élément de marquage (11) est monté de manière amovible et réversible sur l'élément de commutation mobile ou sur un composant (4) du commutateur (1-3) qui se déplace lors du mouvement de l'élément de commutation mobile (1).

4. Procédé selon l'une quelconque des revendications 1 à 3,
dans lequel le schéma de magnétisation (40) présente un schéma de marquages magnétiques (41, 42) qui se répète périodiquement le long d'une direction (49), dans lequel la direction (49) est agencée parallèlement à une direction de mouvement (8) de l'élément de commutation mobile (1).

5. Procédé selon l'une quelconque des revendications 1 à 3, dans lequel le schéma de magnétisation (50) est codé de manière absolue.

6. Dispositif de contrôle d'une opération de commutation d'un commutateur électrique (1-3) qui présente un élément de commutation mobile (1), dans lequel le dispositif (10) comprend :
- un élément de marquage (11) qui présente un schéma de magnétisation (40 ; 50) qui comprend plusieurs marquages magnétiques (41, 42 ; 51-58),
- un capteur (12) pour détecter un mouvement relatif entre l'élément de marquage (11) et le capteur (12) et
- une unité de traitement (13) qui est couplée au capteur (12) et qui est conçue de manière à déterminer une longueur de trajet (7) du mouvement relatif détecté par le capteur (12),
**caractérisé par**
un dispositif de fixation mobile fixable (14) pour la fixation amovible du capteur (12) sur un cadre (3) du commutateur électrique (1-3), dans lequel le dispositif de fixation (14) comprend un bras mobile qui comprend au moins un élément rigide (16, 18) et au moins un joint sphérique fixable (17, 19).

7. Dispositif selon la revendication 6, comprenant :
un moyen de support (32 ; 33) pour monter de manière amovible et réversible l'élément de marquage (11) sur l'élément de commutation mobile (1) ou sur un composant (4) du commutateur électrique (1-3), qui se déplace lors d'un mouvement de l'élément de commutation mobile (1).

8. Dispositif selon la revendication 6 ou la revendication 7,
dans lequel le schéma de magnétisation (40) présente un schéma de marquages magnétiques (41, 42) qui se répète périodiquement le long d'une direction (49).

9. Dispositif selon la revendication 6 ou la revendication 7,
dans lequel le schéma de magnétisation (50) est codé de manière absolue.

10. Dispositif selon l'une quelconque des revendications 6 à 9,
dans lequel le dispositif de fixation (14) comprend au moins un autre bras pour soutenir le capteur (12).
